# EUROPÄISCHE PATENTANMELDUNG

(11) **EP 1 334 820 A2**
(43) Veröffentlichungstag der Anmeldung: **13.08.2003**
(21) Anmeldenummer: 03000256.2
(22) Anmeldetag: 08.01.2003
(51) Int. Cl.: B30B 15/06

(54) **Pressestempel für eine Laminierpresse und Verwendung**

(30) Priorität: 07.02.2002 DE 10205153; 26.04.2002 DE 10218719
(71) Anmelder: W.C. Heraeus GmbH & Co. KG, 63450 Hanau (DE)
(72) Erfinder: Bauer, Alfred, 63755 Alzenau (DE); Hartmann, Horst, 63454 Hanau (DE); Kolodzel, Günter, 63791 Karlstein (DE); Rabe, Michael, 63486 Bruchköbel (DE)
(74) Vertreter: Kühn, Hans-Christian

(57) **Zusammenfassung**

Die Erfindung betrifft einen Pressstempel für eine Laminierpresse mit einem Ober- (2) und einem Unterstempel (3), wobei Ober- und/oder Unterstempel beheizbare Pressflächen zur Zufuhr von Wärme zum Pressgut aufweisen und besteht darin, dass mindestens die Pressfläche des Ober (2) und/oder des Unterstempels (3) zumindest teilweise aus einem wärmebeständigen Kunststoff (5) gebildet ist und die Pressfläche des Ober-und/oder des Unterstempels aus mehreren voneinander getrennten Teilflächen gebildet ist und/oder Unterbrechungen aufweist.

## Beschreibung

Die Erfindung betrifft einen Pressstempel für eine Laminierpresse mit einem Ober- und einem Unterstempel, wobei Ober- und/oder Unterstempel beheizbare Pressflächen zur Zufuhr von Wärme zum Pressgut aufweisen.

Derartige Pressstempel sind aus DE 35 39 990 A1 oder DE 85 18 808 U1 bekannt. Sie werden unter anderem in Laminierpressen benötigt zum Herstellen von Folienverbunden gemäß EP 656 310 B1 oder EP 775 054 B1. Solche Folienverbunde weisen mindestens eine Metallfolie und mindestens eine Kunststofffolie auf. Sie werden unter anderem zur Herstellung von Leiterbahnstrukturen verwendet, auf denen Mikrochips aufgebracht werden. Die derart gebildeten Module werden unter anderem eingesetzt in sogenannten Smartcards, wie Kreditkarten oder Telefonkarten, Flip-Chips, Halbleiter-Träger oder Schaltungssubstrate.

Die zu laminierenden Folien sind sehr dünn. Typischerweise sind die Kunststofffolien etwa 20 bis 200 µm dick und die Metallfolien weisen eine Dicke von etwa 20 bis 100 µm auf. Aufgrund der geringen Abmessungen der Strukturen ist eine hohe Fertigungsgenauigkeit erforderlich. Die strukturierten Kunststoff- und Metall-Folien müssen nicht nur definiert übereinander angeordnet sondern auch sehr genau laminiert werden. Da zum Laminieren der Pressstempel zumindest teilweise erwärmt werden muss, besteht die Möglichkeit, dass sich dieser durch die Erwärmung leicht verzieht, so dass die Pressflächen nicht exakt parallel zueinander angeordnet sind. Dadurch entsteht an unterschiedlichen Stellen des Folienverbundes ein unterschiedlicher Pressdruck beim Laminieren, so dass die Qualität des Laminats ungünstig beeinflusst werden kann.

Häufig sind die zur Herstellung von Leiterbahnstrukturen verwendeten Metallfolien derart fein strukturiert, dass sie zu ihrer Verarbeitung auf eine Trägerfolie aus Kunststoff aufgebracht werden müssen. Teilweise werden Metallfolien unter Verwendung einer Kleberschicht mit Kunststofffolien laminiert. Bei den Laminiervorgängen kann es aufgrund der Wärmeentwicklung dazu kommen, dass erweichter bzw. geschmolzener Kunststoff an den Pressflächen haften bleibt.

Aufgabe der vorliegenden Erfindung ist es, die bekannten Pressstempel zu verbessern, um die genannten Probleme bei der Herstellung von Laminatstrukturen weitestgehend zu beseitigen.

Die Aufgabe wird erfindungsgemäß dadurch gelöst, dass mindestens die Pressfläche des Oberund/oder des Unterstempels zumindest teilweise aus einem wärmebeständigen Kunststoff gebildet ist, wobei die Pressfläche des Ober- und/oder des Unterstempels aus mehreren voneinander getrennten Teilflächen gebildet ist und/oder Unterbrechungen aufweist. Unter wärmebeständig wird dabei ein solcher Kunststoff verstanden, der üblicherweise zum Einsatz bei Laminiertemperaturen bis etwa 20 - 300°C vorzugsweise 200°C geeignet ist. Im Sinne der Erfindung kann auch der Oberstempel und/oder der Unterstempel vollständig aus Kunststoff gebildet sein. Es kann auch lediglich die Pressfläche oder ein Teil davon aus einer Kunststoffplatte oder einer Kunststoffschicht gebildet sein.

Vorzugsweise eignen sich hierzu Silikon oder auch Teflon. Auch andere wärmebeständige und elastische Kunststoffe können geeignet sein. Durch die erfindungsgemäße Anordnung des Kunststoffs wird gewährleistet, dass ein nahezu gleicher Druck an jeder zu laminierenden Stelle ausgeübt wird, so dass eine gleichmäßige Laminierqualität erzielt wird. Ungleichmäßigkeiten der Pressflächen oder unterschiedliche Materialstärken sowie eine Anordnung von flachen Bauelementen auf einer Folie (sofern der Kunststoff eine ausreichende Dicke aufweist) werden so bis zu einem gewissen Grad aufgrund der Elastizität des Kunststoffes ausgeglichen. Durch den Kunststoff wird eine Art Antihafteffekt erzielt, der verhindert, dass Bestandteile des Folienverbundes oder Kunststoffreste an den Pressflächen haften bleiben. Dies ist wichtig, um ein üblicherweise getaktetes Heranführen der Folienbahnen in die Laminierpresse bzw. zwischen Ober- und Unterstempel des Pressstempels zu sichern. Vorzugsweise weist der Kunststoff in Pressrichtung, also senkrecht zur Pressfläche, eine Dicke von etwa 20 bis 10.000 µm, insbesondere von etwa 150 bis 250 µm auf.

Unterbrochene Flächen oder Teilflächen können gebildet werden durch Einbringen von Nuten oder Bohrungen in Ober- und/oder Unterstempel. Dies kann vorteilhaft sein, um lediglich eine Heftung an definierten Punkten der Folien und kein großflächiges Laminieren durchzuführen. Eine Unterbrechung oder Teilung mindestens einer der Pressflächen ist auch insofern vorteilhaft, als dadurch Folien laminiert werden können, auf denen bereits vor dem Laminieren Bauteile, wie beispielsweise Mikrochips, aufgebracht wurden. In diesem Fall sind die Unterbrechungen so anzuordnen, wie es der Anordnung der Bauteile auf der Folie entspricht, damit diese dann beim Laminieren in den Unterbrechungen platziert werden können.

Erfindungsgemäß kann ein Pressstempel für Verwendung eines Pressstempels für eine Laminierpresse mit einem Ober- und einem Unterstempel, wobei Ober- und/oder Unterstempel beheizbare Pressflächen zur Zufuhr von Wärme zum Pressgut aufweisen, wobei mindestens die Pressfläche des Ober- und/oder des Unterstempels zumindest teilweise aus einem wärmebeständigen Kunststoff gebildet ist zum Laminieren eines Folienverbundes verwendet werden. Mit der Erfindung ist ein passgenaues Laminieren von strukturierten endlosen Folienbändern möglich.

Nachfolgend wird die Erfindung an Hand einer Zeichnung beispielhaft erläutert. In der Zeichnung zeigt:

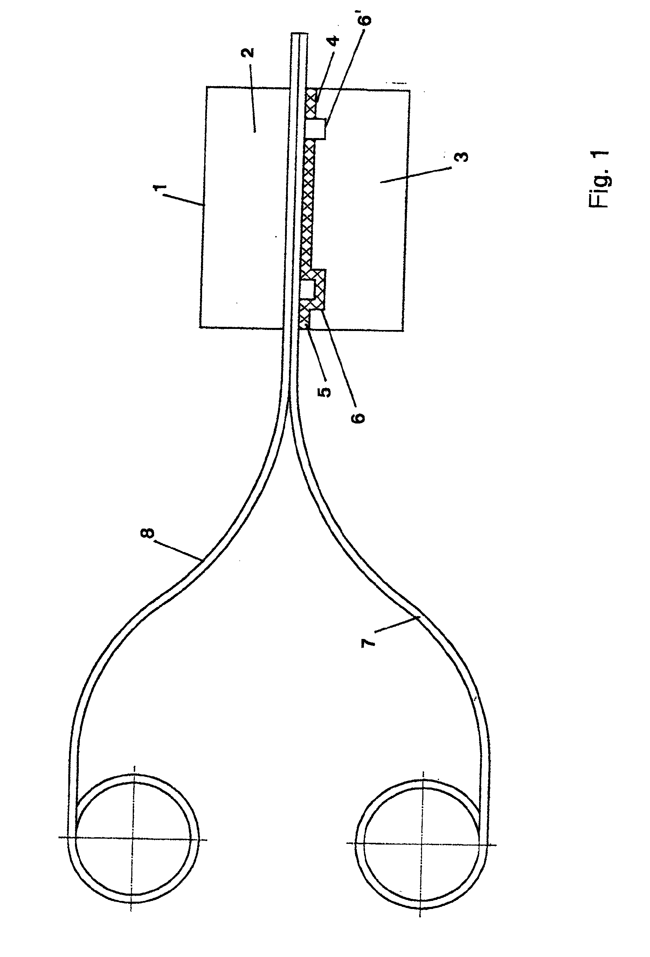

Fig. 1 einen Pressstempel mit zu laminierenden Folien und
Fig. 2 einen Pressstempel zum Laminieren mit Bauteilen bestückter Folien.

Ein Pressstempel 1 ist in einer in der Zeichnung nicht dargestellten, dem Fachmann jedoch beispielsweise aus DE 85 18 808 U1 bekannten Laminierpresse angeordnet. Der Pressstempel 1 weist einen Oberstempel 2 und einen Unterstempel 3 auf. Die Pressfläche 4 des Unterstempels 3 ist mit einer Kunststoffschicht 5 aus Silikon bedeckt. Der Unterstempel 3 weist Nuten 6;6' auf, mit denen die Pressfläche 4 in Teilflächen geteilt wird. Beispielhaft wurde die Nut 6 in den Unterstempel 3 eingebracht, bevor die Kunststoffschicht 5 aufgebracht wurde und die Nut 6' wurde nach dem Aufbringen der Kunststoffschicht 5 in den Unterstempel 3 eingebracht. Dadurch ist Nut 6 an ihren Flächen ebenfalls beschichtet, während die Flächen der Nut 6' keine Kunststoffbeschichtung aufweisen. Die Beschichtung kann auf dem Oberstempel 2 oder dem Unterstempel 3 oder auf beiden zugleich erfolgen.

Bei der dargestellten Anordnung kann die unten, entlang der Kunststoffschicht 5 laufende Folie 7 eine Kupferfolie sein, auf die eine weitere Folie 8 aufgebracht wird. Die Folie 8 kann eine Kunststofffolie sein oder als bereits vorhandenes Laminat aus mehreren Folien gebildet sein, wobei dieses Laminat der Folie 8 aus einer Kombination mindestens einer Kunststofffolie mit mindestens einer Metallfolie oder aus mehreren Kunststofffolien oder Metallfolien gebildet sein kann. Vor dem Laminieren ist eine Metallfolie oder Kunststofffolie mit einer Schicht eines Klebers versehen.

Die Folien werden in der Regel getaktet zwischen Ober- und Unterstempel 2;3 geführt, so dass in einer Pause zwischen zwei Vorschub-Phasen durch Zusammenpressen von Ober- und Unterstempel 2;3 laminiert wird.

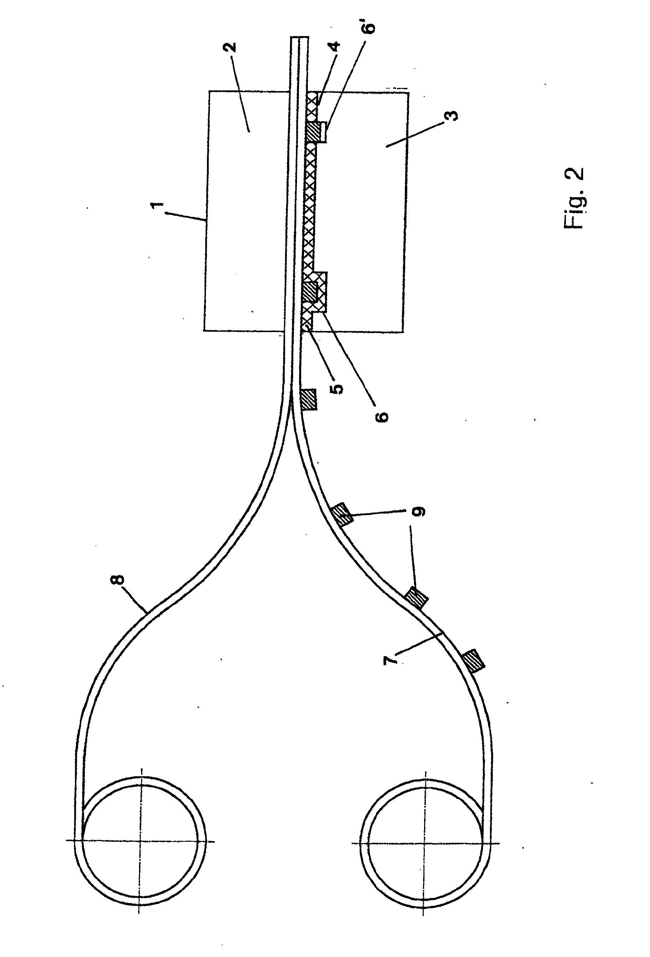

Figur 2 zeigt eine ähnliche Anordnung, wobei auf Folie 7 bereits Bauteile 9 (beispielsweise integrierte Schaltkreise) angeordnet sind. In dem Fall sind die Nuten 6 bzw. 6' im gleichen Abstand in dem Unterstempel 3 angeordnet wie die Bauteile 9 auf der Folie 7. Die Zufuhr der Folien 7;8 zu dem Pressstempel 1 erfolgt dergestalt, dass die Bauteile 9 beim Pressen innerhalb der Nuten 6;6' angeordnet sind.

## Patentansprüche

1. Pressstempel für eine Laminierpresse mit einem Ober- und einem Unterstempel, wobei Ober- und/oder Unterstempel beheizbare Pressflächen zur Zufuhr von Wärme zum Pressgut aufweisen, wobei mindestens die Pressfläche des Ober- und/oder des Unterstempels zumindest teilweise aus einem wärmebeständigen Kunststoff gebildet ist und wobei die Pressfläche des Ober- und/oder des Unterstempels aus mehreren voneinander getrennten Teilflächen gebildet ist und/oder Unterbrechungen aufweist .

2. Pressstempel nach Anspruch 1, **dadurch gekennzeichnet, dass** der Kunststoff aus Silikon oder Teflon gebildet ist.

3. Pressstempel nach Anspruch 1 oder 2, **dadurch gekennzeichnet, dass** der Kunststoff eine Dicke von etwa 20 bis 10.000 µm, vorzugsweise von etwa 150 bis 250 µm, aufweist.

4. Verwendung eines Pressstempels für eine Laminierpresse mit einem Ober- und einem Unterstempel, wobei Ober- und/oder Unterstempel beheizbare Pressflächen zur Zufuhr von Wärme zum Pressgut aufweisen, wobei mindestens die Pressfläche des Oberund/oder des Unterstempels zumindest teilweise aus einem wärmebeständigen Kunststoff gebildet ist zum Laminieren eines Folienverbundes.
